# EUROPÄISCHE PATENTSCHRIFT

(11) **EP 0 680 064 B1**
(45) Veröffentlichungstag und Bekanntmachung des Hinweises auf die Patenterteilung: **21.01.1998**
(21) Anmeldenummer: 95106102.7
(22) Anmeldetag: 24.04.1995
(51) Int. Cl.: H01H 35/02, H01H 1/00

(54) **Mikromechanisches Bauteil mit einem Schaltelement als beweglicher Struktur, Mikrosystem und Herstellverfahren**
Micromecanical element with a contactor part as mobile structure, microsystem and method for manufacturing
Elément micromécanique avec un élément de contact comme structure mobile, micro-système et procédé de fabrication

(30) Priorität: 28.04.1994 DE 4414970
(43) Veröffentlichungstag der Anmeldung: 02.11.1995
(73) Patentinhaber: SIEMENS AKTIENGESELLSCHAFT, 80333 München (DE)
(72) Erfinder: Zettler, Thomas, Dr., D-81737 München (DE)

(56) Entgegenhaltungen:
- US-A- 3 955 356
- TECHNICAL DIGEST. IEEE SOLID-STATE SENSOR AND ACTUATOR WORKSHOP (CAT. NO.92TH0403-X), HILTON HEAD ISLAND, SC, USA, 22-25 JUNE 1992, ISBN 0-7803-0456-X, 1992, NEW YORK, NY, USA, IEEE, USA, Seiten 126-131, WEIJIE YUN ET AL 'Surface micromachined, digitally force-balanced accelerometer with integrated CMOS detection circuitry'

## Beschreibung

Die Erfindung betrifft ein mikromechanisches Bauteil mit einer festen mikromechanischen Struktur, die zwei Elektroden umfaßt, und einer beweglichen mikromechanischen Struktur, ein Mikrosystem auf einem Halbleitersubstrat mit einer integrierten Schaltung und dem mikromechanischen Bauteil sowie ein Herstellverfahren.

Mikromechanische Bauteile werden zu verschiedenen Zwecken eingesetzt, bekannt sind bspw. proportionale und nichtproportionale Kraftsensoren (Beschleunigungs-und Neigungssensoren), Motoren und Aktoren. Sie besitzen feste und bewegliche mikromechanische Strukturen und ihre Funktion basiert in den meisten Fällen auf elektrostatischen Kräften, insbesondere zwischen Kondensatorflächen mit variablem Abstand (s.zB. den Artikel von Sherman et al., Conf. Proc. IEDM 1992, S.501 (Nr. 0-7803-0817-4/92 IEEE).

Bei der Herstellung von derartigen mikromechanischen Bauteilen besteht ein großes Interesse an Prozessen, die mit der Fertigung von integrierten Schaltungen, insbesondere auf einem Silizium-Substrat, kompatibel sind. Nur eine Kompatibilität der Herstellungsprozesse erlaubt die Integration von Mikromechanik und Ansteuer- oder Auswerteschaltungen in Mikrosystemen. Dies ist auch dann wichtig, wenn bestehende Halbleiterfertigungsanlagen auch zur Herstellung von mikromechanischen Strukturen genutzt werden sollen. Besonders vorteilhaft wäre ein Prozeß, mit dem gleichzeitig eine integrierte Schaltung und ein mikromechanisches Bauteil in verschiedenen Bereichen des Halbleitersubstrats erzeugt werden, d.h. ein Mikrosystem mit nur minimalem zusätzlichem Prozeßaufwand zur integrierten Schaltung hergestellt wird.

Für mikromechanische Bauteile sind u.a. folgende Herstellprozesse bekannt:
a) Polysilizium Center-pin- und Flange-Prozeß (M. Mehrengany, Y.-C. Tai, J. Micromech. Microeng., vol. 1, 73, 1991)
   Dieser Prozeß erfordert bei der Herstellung der mikromechanischen Strukturen im Anschluß an die Herstellung der integrierten Schaltung zusätzliche Polysiliziumabscheidungen nach dem Metallisierungskomplex. Im Fall, daß der Center-Pin-Prozeß vor der Metallisierung der integrierten Schaltung durchgeführt werden soll, ergibt sich das Problem, die beweglichen Strukturen freizuätzen, und gleichzeitig die Isolation der Metallisierung zu schützen. Ein weiterer Nachteil ist der relativ hohe spezifische Widerstand von dotiertem Polysilizium.
b) Polysilizium LOCOS-Prozeß (L.S. Tavrow et al, Sensors and Actuators A, Phys. vol. A35, 33, 1992):
   Der Prozeß sieht vor, die beweglichen mikromechanischen Strukturen auf einer planen LOCOS-Oxidschicht herzustellen, wobei der Oxidationsschritt wegen der Temperaturbelastung nur vor der Transistorherstellung einer integrierten Schaltung erfolgen. Bei vollständiger Durchführung des Prozesses vor Herstellung der integrierten Schaltung ergibt sich eine ungünstige Topologie für die Nachfolgeschritte sowie das Problem, die mikromechanischen Strukturen während der Herstellung der integrierten Schaltung zu schützen. Bei einer ineinander verzahnten Herstellung muß das Problem der Freiätzung des Rotors bei gleichzeitigem Schutz der Schaltungsisolationsoxide gelöst werden.
c) Selektiver Wolfram-Prozeß (L.Y.Chen et al, TRANSDUCERS '91., Int. Conf. on Solid-State Sensors and Actuators. San Francisco, USA, IEEE Cat. No. 91CH2817-5, 739, 1991):
   Dieser Prozeß kann im Anschluß an einen Schaltungs-Fertigungsprozeß durchgeführt werden, wobei das Problem der elektrischen Kontaktierung und des Schutzes der Metallisierungsisolation durch das vorgeschlagene Verfahren nicht gelöst werden. Der Prozeß ist insbesondere bezüglich der Lithographieschritte sehr aufwendig.
d) LIGA-Prozeß (P.Bley et al, Microelectronic Engineering 13, 509, 1991; H. Guckel et al, Conf. Proceedings IEEE-Micro Electro Mechanical Systems, Nara, Japan, 1991): Dieser Prozeß benötigt Röntgenstrahl-Lithographie und eventuell eine nachträgliche Montage von losen mikroskopischen Bauteilen.

Alle diese Prozesse sind in ihrer Konzeption nicht für die gemeinsame und insbesondere gleichzeitige Fertigung von integrierter Schaltung und dem mikromechanischen Bauteil in einem Mikrosystem ausgelegt. Sie benötigen eine Vielzahl von Schichten und Prozeßschritten, welche ausschließlich der Herstellung des mikromechanischen Bauteils dienen und die für die Herstellung einer integrierten Schaltung überflüssig oder sogar einschränkend oder nachteilig sind.

Der Erfindung liegt daher die Aufgabe zugrunde, ein neuartiges mikromechanisches Bauteil anzugeben, das als Sensorschalter eingesetzt werden kann, einschließlich eines einfachen Herstellverfahrens , sowie ein Mikrosystem mit einer integrierten Schaltung und dem mikromechanischen Bauteil und ein Herstellverfahren anzugeben, bei welchem ausgehend von der IS-Herstellung kein oder ein nur minimaler zusätzlicher Prozeßaufwand für die Herstellung des mikromechanischen Bauteils notwendig ist.

Diese Aufgabe wird durch die Merkmale der Ansprüche 1, 8, 14 und 18 gelöst.

Die Erfindung beruht auf der Verwendung der beweglichen Struktur als Schaltelement zwischen zwei voneinander isolierten festen Elektroden; ein solcher Schalter ist makroskopisch als sogenannter Quecksilberschalter bekannt. Je nach Lage des beweglichen leitenden Schaltelementes stellt dieses eine elektrische Verbindung zwischen den Elektroden her oder nicht.

Vorzugsweise besitzt das Bauteil eine Sicherung gegen Herausfallen des Schaltelementes, die aus einer höherliegenden Schicht gebildet ist. Diese Schicht kann leitend oder nichtleitend sein, sie kann über der beweglichen Struktur gitterförmig strukturiert sein. Da die Sicherung i.a. vor Freiätzen des Schaltelementes hergestellt wird, muß sie so strukturiert sein, daß sie das Freiätzen mittels eines Ätzprozesses mit isotroper Komponente erlaubt. Nach der Freiätzung kann das Bauteil mithilfe einer Abdeckschicht, die möglichst nicht-konform abgeschieden wird, hermetisch verschlossen werden, so daß es gegen äußere Einflüsse geschützt und mechanisch sehr stabil ist.

Das Bauteil kann als nicht-proportionaler Kraftsenssor (Ereignissensor) genutzt werden, indem man die Trägheitskraft auf das bewegliche Schaltelement ausnutzt und einen Kurzschluß (oder eine Unterbrechung) zwischen den (von außen anschließbaren Elektroden nachweist. Es ist jedoch genauso möglich, andere Krafteinwirkungen auf die bewegliche Struktur, bspw. einer strömenden Flüssigkeit oder eines Gases oder die direkte Krafteinwirkung eines externen mechanischen Bauteils zu detektieren.

Bei dem erfindungsgemäßen Herstellverfahren werden das Schaltelement und die Elektroden aus derselben oder aus verschiedenen leitenden Schichten strukturiert. Feste und bewegliche Strukturen sind dabei zunächst durch mindestens eine isolierende Schicht voneinander und zumindest die bewegliche Struktur auch vom Substrat getrennt. Dann wird eine Maske aufgebracht und ein Ätzprozeß mit einer isotropen Komponente durchgeführt, der die isolierende Schicht mindestens um das Schaltelement herum selektiv zu der leitenden Schicht oder den leitenden Schichten entfernt. Nach dem Ätzprozeß ist das Schaltelement entweder frei beweglich und besitzt keine Verbindung mehr zum übrigen Bauteil oder es ist noch über durchtrennbare Schmelzsicherungen (Fuses) mit ihm verbunden. Die Elektroden sind zumindest an einer ihrer Oberflächen (die dem Schaltelement zugewandt ist) freigelegt, so daß das Schaltelement bei Bewegung einen Kontakt zwischen den Elektroden über diese Oberflächen herstellen kann.

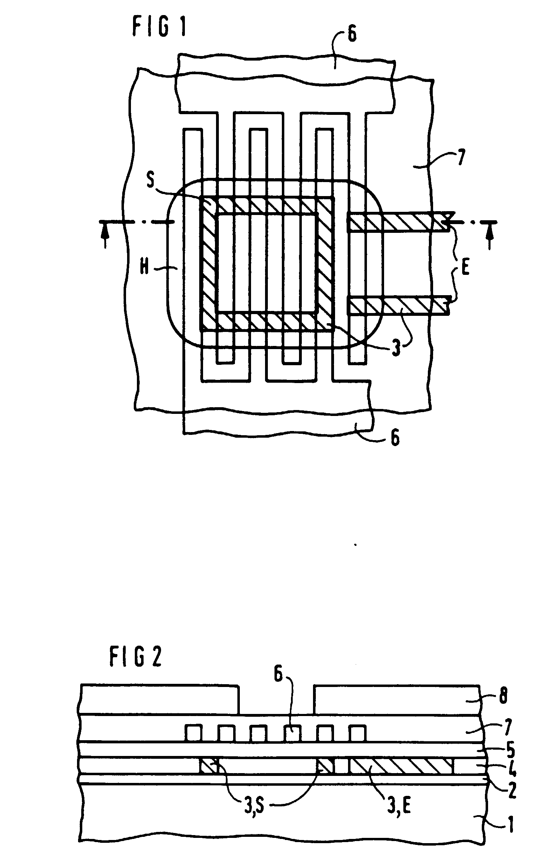

Die Erfindung umfaßt auch ein Mikrosystem mit einer Integrierten Schaltung (IS) und dem mikromechanischen Bauteil (BT). Bei dem Mikrosystem werden eine oder mehrere leitende Schichten, die bereits für die integrierte Schaltung, z.B. ihre Verdrahtung, benötigt werden, als Teile des mikromechanischen Bauteils verwendet. Diese Schicht oder Schichten müssen lediglich durch ein entsprechendes Design so strukturiert werden, daß im Bereich des mikromechanischen Bauteils mindestens zwei Elektroden als feste mikromechanische Strukturen und ein Schaltelement als bewegliche mikromechanische Struktur gebildet werden. Als Ätzprozeß mit isotroper Komponente kann der bei der IS-Herstellung bereits zur Freiätzung der Anschlußpads benötigte Prozeß genutzt werden, die dabei eingesetzte Maske muß lediglich im Bereich des Bauteils geeignet ausgebildet sein, so daß das Schaltelement und eine Oberfläche der Elektroden freigelegt werden . Die integrierte Schaltung kann eine Ein- oder Mehrlagenverdrahtung (d.h. eine oder mehrere Metallisierungsebenen) aufweisen, von denen eine, mehrere oder alle für das mikromechanische Bauteil verwendet werden können. Die Integrierte Schaltung kann in einer beliebigen Technologie, bspw. CMOS, ausgeführt sein. Vorzugsweise umfaßt sie eine Auswerteschaltung, mit der die Elektroden direkt verbunden sind.Ein Ausschnitt aus einer solchen Schaltung ist in den Figuren 1 und 2 der deutschen Patentanmeldung "Mikrosystem mit integrierter Schaltung und mikromechanischen Bauteil und Herstellverfahren" desselben Erfinders und desselben Anmeldetags dargestellt, auf die diesbezüglich verwiesen wird.

Die Erfindung wird im folgenden anhand von Ausführungsbeispielen, die in den Figuren dargestellt sind, näher erläutert. Es zeigen:

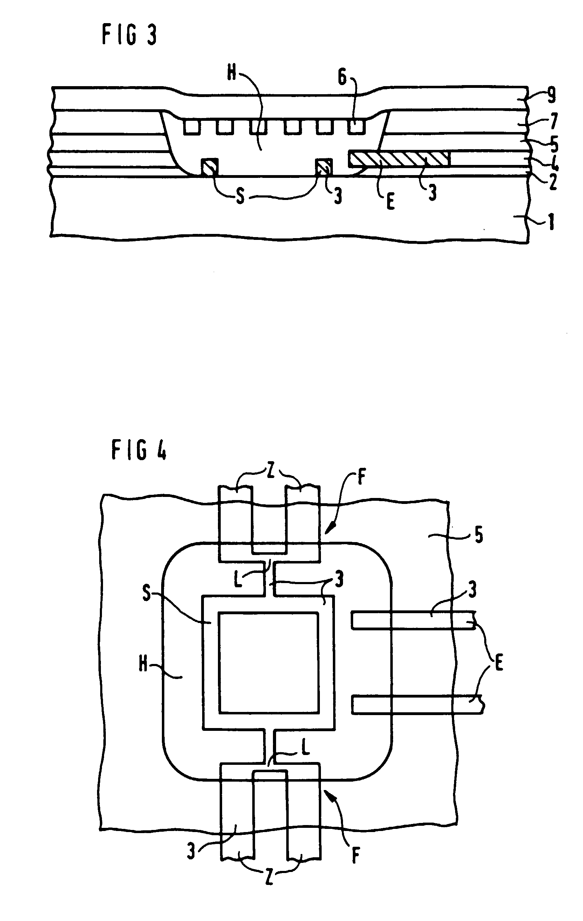

- FIG 1 - 3: eine Aufsicht auf und einen Querschnitt durch ein Halbleitersubstrat im Bereich des mikromechanischen Bauteils, an dem das Verfahren verdeutlicht wird,
- FIG 4: eine Aufsicht auf ein mikromechanisches Bauteil gemäß einer weiteren Ausführungsform der Erfindung.

### FIG 1 - 3:

In der dargestellten Ausführungsform weist das mikromechanische Bauteil zwei Elektroden E und ein bewegliches Schaltelement S in Form eines Bügels auf, die aus derselben leitenden Schicht 3 strukturiert sind. Das Schaltelement S und ein Ende jeder Elektrode befinden sich in einem Hohlraum H, wobei die Strukturen und der Hohlraum so dimensioniert sind, daß bei Bewegung des Schaltelements ein elektrischer Kontakt zwischen den Elektroden hergestellt oder unterbrochen werden kann. Die Elektroden sind von außen anschließbar. Im Ausführungsbeispiel sind die Elektroden an derselben Hohlraumwand angeordnet. Vorzugsweise ist eine Sicherung gegen Herausfallen des Schaltelementes S vorgesehen, die aus einer über dem Hohlraum gitterförmig strukturierten Schicht bestehen kann. Die Seitenwände des Hohlraums H werden von den Kontaktflächen der Elektroden E sowie von einer unteren isolierenden Schicht 2, einer mittleren isolierenden Schicht (hier Doppelschicht) 4,5, und einer oberen isolierenden Schicht 7 gebildet, in die die Elektroden teilweise eingebettet sind. Der Boden des Hohlraums wird von einem Substrat 1 gebildet, nach oben kann der Hohlraum zusätzlich durch eine Abdeckschicht 9 hermetisch verschlossen sein (in Fig.1 ist die Abdeckschicht 9 nicht dargestellt).

In FIG 2 ist ein Substrat 1 mit beliebiger Oberfläche (z.B. Silizium, ein Feldoxid oder eine geeignete Ätzstopschicht) dargestellt.Auf dem Substrat wird eine untere isolierende Schicht 2 aufgebracht und ggf. strukturiert. Auf dieser wird eine leitende Schicht 3, bspw. eine erste Metallisierungsebene, aufgebracht und zu Elektroden E und Schaltelement S strukturiert. Dabei und bei der Dicke der unteren isolierenden Schicht 2 (bzw. der späteren Ätztiefe) sind die oben erläuterten Dimensionierungen zu beachten. Es werden eine oder mehrere mittlere isolierende Schichten 4,5 aufgebracht und ggf. planarisiert . Als Sicherung gegen das Herausfallen des später freizulegenden beweglichen Schaltelements wird eine Schicht 6 aufgebracht und über dem späteren Hohlraum in geeigneter Weise, beispielsweise gitterförmig, strukturiert. Die Sicherung wird mit einer oberen isolierenden Schicht 7 abgedeckt.

Nachfolgend wird ein Ätzprozeß durchgeführt, wofür entweder eine Maske 8 aufgebracht wird, die eine Öffnung oberhalb des freizulegenden beweglichen Schaltelement S aufweist, oder es wird Schicht 6 als Maske verwendet (die dann insbesondere am Rand und außerhalb des Hohlraums geeignet strukturiert sein muß). Es werden die isolierenden Schichten 2, 4, 5, 7 geätzt. Dabei müssen folgende Bedingungen berücksichtigt werden:
- Der Ätzprozeß muß ausreichend selektiv zu der leitenden Schicht 3 und in diesem Beispiel auch zum Gitter 6 sein,
- die isotrope Komponente des Ätzprozesses und die Größe der Öffnung in der Maske müssen unter Berücksichtigung der einzelnen Schichtdicken so gewählt sein, daß das Schaltelement S völlig unterätzt und frei beweglich wird. Die dem Schaltelement zugewandte Seite der Elektroden muß ebenfalls freigeätzt werden.
Der Ätzprozeß wird vorzugsweise als Naßätzung mit einer gepufferten HF-Lösung oder als mikrowellenunterstützte Trockenätzung durchgeführt.

Nach der Freiätzung kann das Bauteil durch eine weitgehend nicht-konforme Abscheidung einer Abdeckschicht 9 verschlossen werden. Ein solches Vorgehen ist in der DE-Anmeldung Nr. 43 32 843.1 "Mikromechanische Vorrichtung und Verfahren zu deren Herstellung" desselben Anmelders, Anmeldetag 27.9.93, beschrieben. Beispielsweise kann Plasmanitrid, PSG oder BPSG in einem Verfahren mit schlechter Kantenbedeckung abgeschieden werden.Das unterliegende Gitter 6 ist für den Prozeß vorteilhaft, aber nicht unbedingt erforderlich.

Für die einzelnen Schritte des Herstellungsverfahrens können die aus der IS-Fertigung bekannten Prozesse und Materialien (bspw. Siliziumoxid als isolierende und Al-Legierungen oder W-haltige Schichten als leitende Schicht) eingesetzt werden.

Das Gitter 6 kann aus einer isolierenden oder leitenden Schicht bestehen. Im zweiten Fall können zusätzlich zu den lateralen Elektroden E auch Gitterelektroden gebildet werden.

### Fig 4 :

Bei mikromechanischen Bauteilen ist das sog. Sticking-Problem bekannt, nämlich das Haften der beweglichen Struktur am Untergrund nach ihrer Freiätzung durch Kapillarkräfte bei der Trocknung (bei Naßätzung). Zur Lösung diesess Problems können bei dem Bauteil ein oder mehrere sog. Fuses (Schmelzsicherungen) vorgesehen sein, wie sie in dem Artikel von W. Yun et al., IEEE-Konferenz 1992, 0-7803-0456-X/92, S.126 beschrieben sind.
In Fig 4 ist eine Aufsicht auf ein derartig verbessertes Bauteil mit zwei Fuses F (ohne Gitter und Abdeckschicht ) dargestellt. Eine Fuse wird aus breiten Zuleitungen Z und einer schmalen Schmelzleitung L, beide bestehend aus einem leitfähigen Material, gebildet. Vorzugsweise wird die leitende Schicht 3 verwendet. Die Fuses halten das Schaltelement S auch nach der Unterätzung fest und verhindern so das Haften am Substrat 1. Nach Abschluß des Herstellprozesses, wie er vorstehend oder nachfolgend unter A - D beschrieben ist, wird durch Anlegen einer Spannung an die Zuleitungen Z ein Strompuls geeigneter Größe und Dauer durch die Schmelzleitungen L geschickt, der zum Aufschmelzen bzw. zur Zerstörung der Fuse an dieser Stelle führt. Dadurch wird das Schaltelement erst zu diesem Zeitpunkt frei beweglich. Da die Zuleitungen Z nach dem Schmelzen von L nicht mehr mit dem Schaltelement elektrisch verbunden sind, können sie nun als Elektroden verwendet werden. Ferner können die Schmelzleitungen auch an den Elektroden selbst vorgesehen sein, so daß diese die Aufgabe der Zuleitungen übernehmen und zusätzliche Fuses entfallen können. Damit können Fuses ohne einen Mehrbedarf an Platz hergestellt werden.
Beim Design der Fuse und bei der Steuerung des Strompulses muß darauf geachtet werden, daß der Strompuls die Schmelzleitung L derart aufschmilzt, daß das Schaltelement von beiden Zuleitungen getrennt und damit frei beweglich wird. Sollen die Zuleitungen später als Elektroden verwendet werden, müssen auch sie sicher voneinander getrennt werden.

Das Bauteil kann in ein Mikrosystem integriert werden, wobei die Herstellung der IS (z.B. Ansteuer- oder Auswerteschaltung) gleichzeitig mit dem beschriebenen Prozeß erfolgt. Dabei werden vorzugsweise folgende Punkte berücksichtigt:
- An dem Substrat 1 werden weitere, für die Herstellung der integrierten Schaltung notwendige Verfahrensschritte vorgenommen, also beispielsweise bei CMOS-Technologie Herstellen von epitaktischen Schichten, dotierten Wannen, Kanalimplantation, Gate-Oxid. Für die Gate-Isolation der IS kann bspw die Schicht 2 verwendet werden. Es wird u.a. eine Implantation der Source/Drain-Gebiete durchgeführt.
- Im IS-Bereich kann die leitende Schicht 3 als erste Metallisierungsebene beispielsweise zum Anschluß von S/D-Gebieten von Transistoren dienen. Die mikromechanischen Strukturen E, S können auch aus der Gate-Ebene gebildet werden, so daß die Schicht 3 aus Polysilizium besteht.
- Als isolierende Schichten werden vorzugsweise - in situ oder durch geeignete Prozesse - planare Schichten eingestzt. Planare Schichten sind auch im Bereich des mikromechanischen Bauteils (BT-Bereich) vorteilhaft.
- Die obere isolierende Schicht 7 kann aus der üblichen Passivierung aus Siliziumoxid und -nitrid bestehen.Die Maske 8, die im BT-Bereich eine Öffnung oberhalb der freizulegenden beweglichen Struktur aufweist, besitzt im IS-Bereich oberhalb der von außen anzuschließenden Pads Öffnungen. Im IS-Bereich muß die isotrope Ätzung auf diesen Anschluß-Pads stoppen.
- Wird das mikromechanische Bauteil mit einem Verschluß versehen, werden getrennte Photomasken und Ätzprozesse für den Hohlraum bzw. die Padfreiätzung eingesetzt, nämlich vor bzw. nach der Abscheidung der Abdeckschicht.
- Für die Sicherung kann bspw. bei einer Mehrlagenverdrahtung eine höherliegende Metallisierungsebene oder eine üblicherweise als Teil der Passivierung verwendete Siliziumnitridschicht eingesetzt werden.

Das Mikrosystem besteht weitestgehend oder sogar vollständig aus Schichten , welche bereits für die integrierte Schaltung benötigt werden, so daß die Herstellung sehr einfach ist. Im einfachsten Fall ist lediglich eine Designmaßnahme (Maskenanpassung) erforderlich.

Im folgenden werden die wesentlichen Punkte von einigen Beispielen erfindungsgemäßer Mikrosysteme dargelegt:
- A:: S + E : Metall 1 (3)
Gitter: Metall 2 (6)

Die Schicht 2 wird durch ein Zwischenoxid auf einem Feldoxid 1 gebildet und ist im IS-Bereich mit den notwendigen Kontaktlöchern versehen. Die Metall-1-Schicht 3 besteht aus AlSiCu , evtl mit Deck- und Basisschicht aus Ti+TiN, und wird im BT-Bereich zu Elektroden und Schaltelement strukturiert. Die mittleren isolierenden Schichten 4,5 werden durch ein planares Intermetalldielektrikum gebildet, in das Vias eingebracht werden. Aus der Metall-2-Schicht 6 werden Leitungen und Pads sowie das Gitter in geeigneter Form hergestellt, als obere isolierende Schicht 7 werden Plasmaoxid und -nitrid (Passivierung) abgeschieden. Mit einer gemeinsamen Fotomaske 9 werden Padöffnung und Hohlraum definiert, und es wird eine isotrope, zu AlSiCu selektive Ätzung durchgeführt, z.B. mit CF₄- oder NF₃-Plasma und evtl. Verdichtung durch Mikrowellen-Anregung. Schließlich wird die Maske 9 entfernt.
Dieser Prozeß erfordert keine zusätzlichen Schritte, sondern nur eine Designanpassung.
- B:: S + E : Metall 1 (3)
Gitter: Metall 2 (6)
hermetischer Verschluß des Hohlraums

Der Prozeß verläuft bis einschließlich der Passivierungs-Abscheidung wie Beispiel A. Dann wird zunächst eine Fotomaske nur für den Hohlraum aufgebracht, dieser geätzt und die Lackmaske entfernt. Nachfolgend wird z.B. Plasmanitrid, Plasmaoxid, BPSG und/oder PSG zum Verschluß abgeschieden und eine Fotomaske für die Padöffnungen aufgebracht. In einem CHF₃/O₂-Plasma werden die Pads freigelegt, anschließend die Lackmaske entfernt.
- C:: S + E : Polysilizium (3)
Gitter: Si₃N₄ (6)
2-Lagen-Metallisierung

Als Änderung zu den bisher beschriebenen Beispielen werden aus dem Gate-Polysilizium das Schaltelement und die Elektroden strukturiert. Die mittlere isolierende Schicht 4 stellt im wesentlichen das Zwischenoxid und die mittlere isolierende Schicht 5 eine Mehrfachschicht bestehend aus einem Teil des Zwischenoxids, dem Intermetalldielektrikum und dem Plasmaoxid der Passivierung dar. Die Schicht 6 besteht aus dem Plasmanitrid der Passivierung und wird zu einem Gitter sowie einer Ätzmaske für die Padöffnungen strukturiert, bspw. in einem CHF₃/O₂-Plasma. Die Maske wird entfernt und eine isotrope Oxidätzung mit gepufferter HF durchgeführt.
Dieser Prozeß benötigt keine Zusatzschichten. Da die isotrope HF-Ätzung u.U. das Metall AlSiCu angreift, können getrennte Fototechniken für Hohlraum und Padöffnungen gewählt werden.
- D:: S + E : Polysilizium (3)
Gitter: Si₃N₄ (6)
hermetischer Verschluß des Hohlraums
2-Lagen-Metallisierung

Der Prozeß verläuft bis einschließlich der Passivierungs-Abscheidung wie Beispiel C. Dann wird zunächst eine Fotomaske zur Definition des Gitters und des Hohlraums aufgebracht und eine anisotrope Si₃N₄-Ätzung durchgeführt, bspw. mit einem CHF₃/O₂-Plasma. Die Maske wird entfernt und unter Verwendung der Si₃N₄-Schicht als Maske wird eine isotrope Oxidätzung zur Erzeugung des Hohlraums durchgeführt. Mithilfe einer nicht-konformen Abscheidung von z.B Plasmanitrid wird dieser verschlossen und eine Maske für die Padfreiätzung aufgebracht, anschließend werden Plasmanitrid und -oxid geätzt.

Bei den beschriebenen Beispielen können Probleme durch Haften des Schaltelementes am Substrat 1 auftreten (sog. Sticking). Diese können entweder durch die bereits beschriebenen Fuses oder dadurch beseitigt werden, daß ohne Trocknung von der HF-Ätzung zum Belacken übergegangen wird, und/oder der Photoresist trocken in einem O₂-Plasma entfernt wird.

## Patentansprüche

1. Mikromechanisches Bauteil mit
- einer festen mikromechanischen Struktur, die mindestens zwei aus einer oder mehreren leitenden Schichten (3) gebildete und voneinander isolierte Elektroden (E) umfaßt, und
- einer beweglichen mikromechanischen Struktur in einem Hohlraum (H), die ein leitendes Schaltelement (S) bildet,
wobei mithilfe des Schaltelementes (S) ein elektrischer Kontakt zwischen den Elektroden (E) herstellbar ist.

2. Mikromechanisches Bauteil nach Anspruch 1, bei dem eine Sicherung gegen Herausfallen des Schaltelementes (S) vorgesehen ist, die mithilfe einer weiteren isolierenden oder leitenden Schicht (6) gebildet ist.

3. Mikromechanisches Bauteil nach einem der Ansprüche 1 bis 2 , bei dem die Elektroden (E) und das Schaltelement (S) aus derselben leitenden Schicht (3) gebildet sind.

4. Mikromechanisches Bauteil nach einem der Ansprüche 1 bis 3, bei dem der Hohlraum (H) nach oben durch eine Abdeckschicht (9) verschlossen ist.

5. Mikromechanisches Bauteil nach einem der Ansprüche 1 bis 4, bei dem mit dem Schaltelement (S) verbundene Schmelzsicherungen (F) vorgesehen sind, an die eine Spannung zur Abtrennung des Schaltelementes anlegbar ist.

6. Mikromechanisches Bauteil nach einem der Ansprüche 2 bis 5, bei dem die Elektroden (E), das Schaltelement (S) und die Sicherung (6) aus metallhaltigen Schichten bestehen.

7. Mikromechanisches Bauteil nach einem der Ansprüche 2 bis 5, bei dem die Elektroden (E)und das Schaltelement (S) aus Polysilium und die Sicherung (6) aus Siliziumnitrid besteht.

8. Herstellverfahren für ein mikromechanisches Bauteil nach einem der Ansprüche 1 bis 7 mit folgenden Schritten:
- Bilden einer unteren isolierenden Schicht (2) auf einem Substrat (1)
- Bilden der festen, die Elektroden bildenden und der beweglichen, das Schaltelement bildenden mikromechanischen Strukturen, die in eine mittlere isolierende Schicht (4,5) eingebettet sind, aus einer oder mehreren leitenden Schichten (3),
- Erzeugen des Hohlraums durch Entfernen der isolierenden Schichten (2, 4, 5) um das Schaltelement (S) und mindestens teilweise an einer Oberfläche jeder Elektrode (E) mit einem Ätzprozeß, der selektiv zum Schaltelement und zu den Elektroden ist und eine isotrope Komponente aufweist.

9. Herstellverfahren nach Anspruch 8, bei dem auf der mittleren isolierenden Schicht (4,5) eine Sicherung gegen Herausfallen aus einer weiteren Schicht (6) gebildet wird, die mit einer oberen isolierenden Schicht (7) abgedeckt wird, wobei der Ätzprozeß die obere isolierende Schicht (7) selektiv zur Sicherung (6) ätzt.

10. Herstellverfahren nach einem der Ansprüche 8 bis 9, bei dem nach Erzeugung des Hohlraums (H) dieser mithilfe einer im wesentlichen nicht-konformen Abscheidung einer Abdeckschicht (9) nach oben verschlossen wird.

11. Herstellverfahren nach einem der Ansprüche 8 bis 10, bei dem mit dem Schaltelement verbundene Schmelzsicherungen (F) nach Erzeugen des Hohlraums (H) durchtrennt werden, so daß das Schaltelement (S) beweglich wird.

12. Herstellverfahren nach Anspruch 16, bei dem als Ätzprozeß eine mikrowellenunterstützte isotrope Trockenätzung durchgeführt wird.

13. Herstellverfahren nach Anspruch 15, bie dem im Ätzprozeß eine gepufferte HF-Lösung verwendet wird.

14. Mikrosystem auf einem Halbleitersubstrat (1) mit
- einem mikromechanischen Bauteil (BT) nach einem der Ansprüche 1 - 7,
- einer integrierten Schaltung (IS) mit Schaltungselementen, die die leitende Schicht (3) beinhalten oder mit ihr verdrahtet sind.

15. Mikrosystem nach Anspruch 14, bei dem die integrierte Schaltung (IS) mehrere leitende Schichten in Form einer Mehrlagenmetallisierung aufweist und die Elektroden (E), das Schaltelement (S) und die Sicherung (6) aus mehreren der Metallisierungsebenen gebildet sind.

16. Mikrosystem nach Anspruch 14 , bei dem die Sicherung (6) mithilfe einer der Passivierung der Integrierten Schaltung dienenden Schicht (6) gebildet ist.

17. Mikrosystem nach einem der Ansprüche 14 bis 16, bei dem die leitende Schicht (3) aus einer Aluminiumlegierung oder im wesentlichen aus Wolfram besteht.

18. Herstellverfahren für ein Mikrosystem nach einem der Ansprüche 14 bis 17, bei dem
- das mikromechanische Bauteil mit einem Verfahren nach einem der Ansprüche 8 bis 13 erzeugt wird,
- aus der leitenden Schicht (3) gleichzeitig mit den mikromechanische Strukturen (S,E) ein Teil eines Schaltungselementes oder eine Verdrahtung im Bereich der Integrierten Schaltung hergestellt werden

19. Herstellverfahren nach Anspruch 18, bei dem der Ätzprozeß zur Erzeugung des Hohlraums (H) gleichzeitig von außen anschließbare Pads der Integrierten Schaltung freilegt.

## Claims

1. Micromechanical element having
- a fixed micromechanical structure, which comprises at least two electrodes (E) which are formed from one or more conductive layers (3) and are insulated from one another, and
- a moveable micromechanical structure in a cavity (H), which structure forms a conductive switching element (S),
it being possible to bring about electrical contact between the electrodes (E) with the aid of the switching element (S).

2. Micromechanical element according to Claim 1, in which protection against the switching element (S) dropping out is provided, which protection is formed with the aid of a further insulating or conductive layer (6).

3. Micromechanical element according to either of Claims 1 or 2, in which the electrodes (E) and the switching element (S) are formed from the same conductive layer (3).

4. Micromechanical element according to one of Claims 1 to 3, in which the cavity (H) is sealed at the top by a covering layer (9).

5. Micromechanical element according to one of Claims 1 to 4, in which fuses (F), which are connected to the switching element (S) and to which a voltage for disconnecting the switching element can be applied, are provided.

6. Micromechanical element according to one of Claims 2 to 5, in which the electrodes (E), the switching element (S) and the protection (6) are composed of layers which contain metal.

7. Micromechanical element according to one of Claims 2 to 5, in which the electrodes (E) and the switching element (S) are composed of polysilicon and the protection (6) is composed of silicon nitride.

8. Manufacturing method for a micromechanical element according to one of Claims 1 to 7 having the following steps:
- a lower insulating layer (2) is formed on a substrate (1)
- the fixed micromechanical structure, which forms the electrodes, and the moveable micromechanical structure, which forms the switching element, which structures are embedded in a middle, insulating layer (4, 5), are formed from one or more conductive layers (3),
- the cavity is produced by removing the insulating layers (2, 4, 5) from around the switching element (S) and at least partially from a surface of each electrode (E) using an etching process which is selective with respect to the switching element and with respect to the electrodes, and which has an isotropic component.

9. Manufacturing method according to Claim 8, in which a protection against dropping out of a further layer (6) is formed on the middle, insulating layer (4, 5), which protection is covered with an upper, insulating layer (7), the etching process etching the upper, insulating layer (7) selectively with respect to the protection (6).

10. Manufacturing method according to either of Claims 8 or 9, in which, after the cavity (H) is produced, it is closed off at the top with the aid of an essentially non-conformal deposition of a covering layer (9).

11. Manufacturing method according to one of Claims 8 to 10, in which fuses (F) which are connected to the switching element are disconnected after the cavity (H) has been produced, so that the switching element (S) becomes moveable.

12. Manufacturing method according to Claim 16, in which microwave-aided isotropic dry etching is carried out as the etching process.

13. Manufacturing method according to Claim 15, in which a buffered HF solution is used in the etching process.

14. Microsystem on a semiconductor substrate (1) having
- a micromechanical element (BT) according to one of Claims 1 - 7,
- an integrated circuit (IS) with circuit elements which contain the conductive layer (3) or are wired to it.

15. Microsystem according to Claim 14, in which the integrated circuit (IS) has a plurality of conductive layers in the form of a multilayer metallization, and the electrodes (E), the switching element (S) and the protection (6) are formed from a plurality of the metallization levels.

16. Microsystem according to Claim 14, in which the protection (6) is formed with the aid of a layer (6) which serves to passivize the integrated circuit.

17. Microsystem according to one of Claims 14 to 16, in which the conductive layer (3) is composed of an aluminium alloy or essentially of tungsten.

18. Manufacturing method for a microsystem according to one of Claims 14 to 17, in which
- the micromechanical element is produced with a method according to one of Claims 8 to 13,
- a part of a circuit element or a wired connection in the region of the integrated circuit is manufactured from the conductive layer (3) simultaneously with the micromechanical structures (S, E).

19. Manufacturing method according to Claim 18, in which the etching process for producing the cavity (H) simultaneously exposes externally connectable pads of the integrated circuit.

## Revendications

1. Composant micromécanique ayant
- une structure micromécanique fixe, qui comprend au moins deux électrodes (E) isolées l'une par rapport à l'autre et formées d'une ou de plusieurs couche(s) (3) conductrices, et
- une structure micromécanique mobile dans une cavité (H), laquelle structure forme un élément (S) de contact conducteur,
un contact électrique pouvant être établi entre les électrodes (E) à l'aide de l'élément (S) de contact.

2. Composant micromécanique selon la revendication 1. dans lequel il est prévu une sécurité empêchant l'élément (S) de contact de tomber, laquelle sécurité est formée par une autre couche (6) isolante ou conductrice.

3. Composant micromécanique selon l'une des revendications 1 à 2, dans lequel les électrodes (E) et l'élément (S) de contact sont formés de la même couche (3) conductrice.

4. Composant micromécanique selon l'une des revendications 1 à 3. dans lequel la cavité (H) est fermée en haut par une couche (9) de recouvrement.

5. Composant micromécanique selon l'une des revendications 1 à 4, dans lequel il est prévu des sécurités fusibles (F) qui sont reliées à l'élément (S) de contact et auxquelles peut être appliquée une tension pour séparer l'élément de contact.

6. Composant micromécanique selon l'une des revendications 2 à 5, dans lequel les électrodes (E), l'élément (S) de contact et la sécurité (6) sont constituées de couches contenant du métal.

7. Composant micromécanique selon l'une des revendications 2 à 5, dans lequel les électrodes (E) et l'élément (S) de contact sont en polysilicium et la sécurité (6) en nitrure de silicium.

8. Procédé de fabrication d'un composant micromécanique selon l'une des revendications 1 à 7, comprenant les étapes suivantes :
- formation d'une couche (2) isolante inférieure sur un substrat (1),
- formation dans une ou plusieurs couches (3) conductrices de la structure micromécanique fixe formant les électrodes et de la structure micromécanique mobile formant l'élément de contact, lesquelles structures sont enrobées dans une couche (4, 5) isolante médiane,
- réalisation de la cavité par élimination des couches (2, 4, 5) isolantes autour de l'élément (S) de contact et au moins en partie au niveau d'une surface de chaque électrode (E) par une opération d'attaque qui est sélective par rapport à l'élément de contact et par rapport aux électrodes et qui comporte un constituant isotrope.

9. Procédé de fabrication selon la revendication 8, dans lequel dans une autre couche (6), on forme sur la couche (4, 5) isolante médiane une sécurité qui empêche l'élément de contact de tomber et est recouverte d'une couche (7) isolante supérieure, l'opération d'attaque attaquant la couche (7) isolante supérieure de manière sélective par rapport à la sécurité (6).

10. Procédé de fabrication selon l'une des revendications 8 à 9, dans lequel après avoir réalisé la cavité (H), on ferme celle-ci en haut à l'aide d'une couche (9) de recouvrement pour l'essentiel non conforme.

11. Procédé de fabrication selon l'une des revendications 8 à 10, dans lequel des sécurités fusibles (F) reliées à l'élément de contact sont sectionnées après la réalisation de la cavité (H) de sorte que l'élément (S) de contact devient mobile.

12. Procédé de fabrication selon l'une des revendications 8 à 10, dans lequel le procédé d'attaque utilisé est une attaque à sec isotrope assistée par micro-ondes.

13. Procédé de fabrication selon la revendication 12, dans lequel on utilise pour l'attaque une solution tamponnée de HF.

14. Microsystème sur un substrat (1) à semi-conducteur comprenant
- un composant (BT) micromécanique selon l'une des revendications 1 à 7,
- un circuit intégré (CI) ayant des éléments de circuit qui incorporent la couche (3) conductrice ou qui lui sont reliés.

15. Microsystème selon la revendication 14. dans lequel le circuit intégré (CI) comporte plusieurs couches sous la forme d'une métallisation multicouche et les électrodes (E), l'élément (S) de contact et la sécurité (6) sont formés de plusieurs des plans de métallisation.

16. Microsystème selon la revendication 14, dans lequel la sécurité (6) est formée à l'aide d'une couche (6) servant à la passivation du circuit intégré.

17. Microsystème selon l'une des revendications 14 à 16, dans lequel la couche (3) conductrice est constituée d'un alliage d'aluminium ou pour l'essentiel de tungstène.

18. Procédé de fabrication d'un microsystème selon l'une des revendications 14 à 17, dans lequel
- on réalise le composant micromécanique par un procédé selon l'une des revendications 8 à 13,
- on fabrique dans la couche (3) conductrice en même temps que les structures (S, E) micromécaniques une partie d'un élément de circuit ou un routage dans la région du circuit intégré.

19. Procédé de fabrication selon la revendication 18, dans lequel l'attaque destinée à réaliser la cavité (H) dégage en même temps des plots de contact du circuit intégré pouvant être raccordés de l'extérieur.
